(19) Europäisches Patentamt

European Patent Office

Office européen des brevets

(11) Veröffentlichungsnummer: **0 286 708 B1**

# (12) EUROPÄISCHE PATENTSCHRIFT

(45) Veröffentlichungstag der Patentschrift: **22.01.92**

(51) Int. Cl.⁵: **H01L 21/31**, G03F 7/20

(21) Anmeldenummer: **87105700.6**

(22) Anmeldetag: **16.04.87**

(54) Verfahren zur Herstellung von Kontaktöffnungen in einer Doppellagenisolation.

(43) Veröffentlichungstag der Anmeldung:
**19.10.88 Patentblatt 88/42**

(45) Bekanntmachung des Hinweises auf die Patenterteilung:
**22.01.92 Patentblatt 92/04**

(84) Benannte Vertragsstaaten:
**DE FR GB IT**

(56) Entgegenhaltungen:
EP-A- 0 227 851
WO-A-87/02179

IBM TECHNICAL DISCLOSURE BULLETIN, Band 27, Nr. 7A, Dezember 1984, Seiten 3990-3993, New York, US; C. ALCORN et al.: "Self-aligned silicon nitride-polyimide double step via hole"

MICROELECTRONIC ENGINEERING, Band 4, Nr. 3, 1986, Seiten 207-219, Elsevier Science Publishers, Amsterdam, NL; M. DESCHLER et al.: "Optimization of via hole plasma etching in polyimide for overlay interconnections"

(73) Patentinhaber: **International Business Machines Corporation**
**Old Orchard Road**
**Armonk, N.Y. 10504(US)**

(72) Erfinder: **Hörner, Eva, Dr.**
**Ulmenstrasse 30/1**
**W-7038 Holzgerlingen(DE)**
Erfinder: **Mühl, Reinhold**
**Würmstrasse 43**
**W-7031 Altdorf(DE)**
Erfinder: **Trumpp, Hans-Joachim, Dr.**
**Eierwiesenstrasse 25**
**W-7024 Filderstadt(DE)**

(74) Vertreter: **Kreidler, Eva-Maria, Dr. rer. nat.**
**IBM Deutschland GmbH Patentwesen und Urheberrecht Schönaicher Strasse 220**
**W-7030 Böblingen(DE)**

IBM TECHNICAL DISCLOSURE BULLETIN, Band 27, Nr. 11, April 1985, Seiten 6783-6784, New York, US; "Via hole etch process through a polyimide/nitride composite layer"

IBM TECHNICAL DISCLOSURE BULLETIN, Band 27, Nr. 10A, März 1985, Seiten 5493-5494, New York, US; "Polyimide profile control by dry etching"

IBM TECHNICAL DISCLOSURE BULLETIN, Band 19, Nr. 9, Februar 1977, Seiten 3413-3414, New York, US; J.A. BONDUR et al.: "Step coverage process with reactive ion etching using thermal resist effects"

IEEE TRANSACTIONS ON MAGNETICS, Band SC-20, Nr. 1, Februar 1985, Seiten 94-103, IEEE, New York, US; D.S. GARDNER et al.: "Layered and homogeneous films of aluminum and aluminum/silicon with titanium and tungsten for multilevel interconnects"

**Beschreibung**

Die Erfindung betrifft ein Verfahren zur Herstellung von Kontaktöffnungen in einer Doppellagenisolation, welches zur Herstellung dieser Öffnungen einen Photoresistprozeß mit Doppelbelichtung und einen mehrstufigen Trockenätzprozeß verwendet. Das Verfahren gemäß der Erfindung wird insbesondere angewendet bei der Herstellung von Kontaktöffnungen in der Doppellagenisolation zwischen erster und zweiter Metallisierung von integrierten Schaltkreisstrukturen in der VLSI-Technologie.

In der integrierten Schaltkreistechnologie wurden Metallisierungsmuster zum Verbinden der einzelnen Bauelemente konventionell in der Weise hergestellt, daß ganzflächig eine Metallschicht auf ein Halbleitersubstrat aufgebracht wurde, welche in einem Photoresistprozeß mit nachfolgender Ätzung entsprechend dem gewünschten Metallisierungsmuster strukturiert wurde. Das Metallisierungsmuster wurde mit einer Isolationsschicht bedeckt, auf die wiederum ein weiteres Metallisierungsmuster aufgebracht wurde, welches über Kontaktöffnungen mit der ersten Metallisierung in Verbindung stand. Mit zunehmender Dichte der integrierten Schaltkreise mußten die Metallisierungsmuster in ihren Dimensionen kleiner und dichter angeordnet werden, was zu einer zunehmenden Unregelmäßigkeit und Unebenheit der Isolationsschichten über den Metallisierungsmustern führte. Wenn eine weitere Metallisierung auf eine solche unebene Isolationsschicht aufgebracht wurde, hatte das zur Folge, daß die Metallisierung über einer Stufe in der Unterlage dünner war, was zu einer Erhöhung der Stromdichte in diesen Bereichen führte und zu Ausfällen durch Elektromigration. Es traten auch Probleme im Zusammenhang mit dem Photoresistprozeß auf, weil eine eindeutige und genaue Belichtung und Entwicklung der Photoresistschichten mit zunehmender Unebenheit der Oberflächen unmöglich wurde.

Im Zuge der Miniaturisierung der Schaltkreisstrukturen wurde das zuvor beschriebene subtraktive Ätzverfahren durch ein sogenanntes Metallabhebeverfahren ersetzt, mit dem sich dichtere Metallisierungsmuster erzeugen ließen. Verfahren dieser Art sind beispielsweise in den US-Patentschriften 2,559,389; 3,849,136 und 3,873,361 beschrieben. Allerdings beseitigt auch dieses zur Herstellung von Metallisierungsmustern angewendete Abhebeverfahren das zuvor diskutierte Unebenheitsproblem nicht.

Eine Methode, welche diese Nachteile überwindet, ist in der US-Patentschrift 3,985,597 beschrieben. Nach diesem Verfahren werden nacheinander 3 Schichten auf ein Substrat aufgebracht, wobei die ersten beiden aus organischem Polymermaterial sind und die dritte, oberste gegen reaktives Ionenätzen in $O_2$ resistent ist. Dann wird eine Photoresistschicht aufgetragen und in dieser das inverse Muster des gewünschten Metallisierungsmusters durch Belichten erzeugt. Nach dem Entwickeln des Resists und dem Entfernen der resultierenden freiliegenden Bereiche der dritten Schicht werden die entsprechenden Bereiche der zweiten und ersten Schicht durch reaktives Ionenätzen entfernt, ein leitendes Metall etwa in der Schichtdicke der ersten Schicht niedergeschlagen, das Substrat einem für die zweite Schicht selektiven Lösungsmittel ausgesetzt und die zweite und alle darüber liegenden Schichten abgehoben. Auf diese Weise wird ein abgesenktes Metallisierungsmuster erhalten. Anschließend wird eine Polyimidschicht aufgetragen, und in einer zweiten Folge von Prozeßschritten werden in dieser Kontaktöffnungen und das Metallisierungsmuster für die Durchführung erzeugt. Obwohl dieses Verfahren sehr effektiv war, traten mit der weiteren, wesentlichen Zunahme der Dichte von Halbleiterbauelementen Schwierigkeiten auf, insbesondere im Zusammenhang mit der Zunahme der Anzahl der Metallisierungslagen. Um die Grundregeln einhalten zu können und eine gute Bedeckung von Metall und Isolationen in allen Lagen zu gewährleisten, wurde deshalb ein Planarprozeß entwickelt, der Gegenstand der Europäischen Patentschrift EP-B- 0 046 525 ist. Bei der nach diesem Verfahren erhaltenen Struktur ist auf einem Halbleitersubstrat mit einem leitenden Metallisierungsmuster zur Isolation eine Verbundschicht aus einer unteren Schicht aus Polyimid und einer oberen, gegen Sauerstoffplasma resistenten anorganischen Isolierschicht angeordnet. Die Kontaktöffnungen in der Verbundschicht werden durch reaktive Ionenätzverfahren hergestellt.

Es wurde auch erkannt (IBM-Technical Disclosure Bulletin Vol. 27, Nr. 10A, März 1985, S. 5835-36), daß es bei Doppellagenisolationen aus Polyimid und einem darauf durch Plasmaabscheidung aufgetragenen Material, beispielsweise von SiN, $SiO_2$, $SiN_xO_y$ und dergl. durch Austritt von Gasen aus dem Polyimid beim Erhitzen auf etwa 350 bis 400 °C zu Fehlstellen in der darüberliegenden SiN-, $SiO_2$- oder $SiN_xO_y$-Schicht und der auf dieser aufgetragenen Metallisierung kommen kann.

Eine Doppellagenisolation, bei der auf die auf Halbleitersubstraten angeordnete erste Metallisierung durch Plasmaabscheidung zuerst eine Nitridschicht aufgetragen und dann eine Polyimidschicht aufgesponnen wird, ist im Tagungsbericht des International Electron Devices Meeting, Washington, DC, Dec. 5-6-7 1983, S. 542-545, R. M. Geffken, beschrieben. Bisher waren bei der Herstellung von Kontaktöffnungen in Isolationsschichten das Fehlen eines Ätzstops auf den darunterliegenden Schichten und die Definition der zweiten Metallisierung die begrenzenden Faktoren hinsichtlich einer dichteren Anordnung der Kontaktöffnungen. Wenn also Isolatoren gewählt werden, welche einen Ätzstop auf der darunterliegenden Schicht haben, könnten die Kontaktöffnungen zwischen zweiter und erster Metallisierung dichter angeordnet werden, indem sie die Linien der ersten Metallisierung überlappen. Bei beiden in dem Bericht beschriebenen Isolatoren sind diese Voraussetzungen erfüllt, d. h. es sind für diese Ätztechnologien mit geeignetem Ätzstop auf der darunterliegenden Topographie bekannt. So ist im Falle des Plasmanitrids bei einer Reihe von Gasmischungen auf der Basis von $CF_4$ das Ätzratenverhältnis von Nitrid zu dem darunterliegenden $PSG/SiO_2$-Substrat größer 10 : 1. In ähnlicher Weise sind für Polyimid Naßätzverfahren auf der Basis von Alkali oder Trockenätzverfahren auf der Basis von $O_2$ bekannt, für die das darunterliegende Oxid und die erste Metallisierung als Ätzstop fungieren.

In der bisherigen Technologie wurden zur Herstellung von Kontaktöffnungen in der Doppellagenisolation zwei Photomasken verwendet, um nacheinander die Öffnungen in der Nitridschicht und dann in der Polyimidschicht herzustellen. Nachteilig an diesem Verfahren ist, daß die Öffnung in der Polyimidschicht, die mit einer anderen Maske erzeugt wird als die in der Nitridschicht, zu derselben nicht selbstjustiert ist. Da die Öffnung in der Polyimidschicht größer ist als die in der Nitridschicht, entstehen auch mehrere steile Stufen, welche von der zweiten Metallisierung bedeckt werden müssen. Insgesamt könnten bei Verwendung von nur einer Maske bei der Herstellung der Kontaktöffnungen in der Doppelschicht eine Reihe von Prozeßschritten eingespart werden, und es könnten selbstjustierte Öffnungen durch beide Schichten mit einem günstigeren Winkel und einem weicheren Profil erhalten werden, was sich auf die Bedeckung mit der zweiten Metallisierung sehr vorteilhaft auswirken würde.

Aufgabe der Erfindung ist deshalb ein Verfahren zur Herstellung von Kontaktöffnungen in einer Doppellagenisolation, welches nur eine Photomaske verwendet.

Die Aufgabe der Erfindung wird gelöst durch eine Kombination von Verfahrensschritten, welche einen Photoresistprozeß mit Doppelbelichtung und einen mehrstufigen Trockenätzprozeß umfaßt und Gegenstand von Patentanspruch 1 ist.

Vorteilhafte Ausgestaltungen der Erfindung sind in den Unteransprüchen niedergelegt.

Die Erfindung wird anhand der Beschreibung und der Figuren 1 bis 10 näher erläutert. Im einzelnen stellen dar:

Fig. 1A     Das Ätzen einer Öffnung in die Nitridschicht nach dem Stand der Technik;

Fig. 1B     Das Ätzen einer Öffnung in eine über der Nitridschicht gemäß Fig. 1A angeordnete Polyimidschicht;

Fig. 2     Eine Resistmaske für die Herstellung von 1/2 Öffnungen in der Doppellagenisolation;

Fig. 3     Den 1. Ätzschritt durch die Polyimidschicht;

Fig. 4     Den 2. Ätzschritt durch dieselbe;

Fig. 5     Den 1. Ätzschritt durch die Nitridschicht;

Fig. 6     Den 2. Ätzschritt zum lateralen Ätzen von Resist und Polyimid über den Winkel des Resists;

Fig. 7     Den 3. Ätzschritt durch die Nitridschicht;

Fig. 8     Den 4. Ätzschritt zum lateralen Ätzen von Resist und Polyimid über den Winkel des Resists und das Strippen des Resists;

Fig. 9     Eine SEM(Rasterelektronenmikroskop)-Aufnahme einer Kontaktöffnung in der Doppellagenisolation aus Nitrid und Polyimid;

Fig. 10     Eine SEM-Aufnahme einer Nitrid/Polyimidwand auf der ersten Metallage.

Plasmanitrid ist aufgrund einiger seiner Eigenschaften sehr gut zur Passivierung integrierter Schaltkreise und als Isolator zwischen einzelnen Metallagen geeignet. Die Plasmanitridfilme stellen in den Schichtdicken, wie sie für Isolationszwecke verwendet werden, eine ausreichende Barriere für Natriumionen dar und schützen deshalb die darunterliegenden Bauelemente gegen ionische Verunreinigungen. Plasmanitrid ist auch verhältnismäßig feuchtigkeitsundurchlässig, was zur Stabilität integrierter Schaltkreise beiträgt. Es besitzt auch, wie eine Reihe anderer Isolatoren, weitere Eigenschaften wie hohe Widerstandswerte, niedrige Werte für Ladungstransport und Fangstellen und eine niedrige bis mäßige Spannung. Es existieren geeignete Prozeßfenster für die Herstellung von Nitridfilmen mit den gewünschten physikalischen und elektronischen Eigenschaften. Plasmanitrid bildet konforme Filme mit ziemlich einheitlichen Schichtdicken über allen Wafertopographien, wodurch Kontaktöffnungen mit sehr enger Toleranz und Unterätzung hergestellt werden können.

Auch Polyimide weisen eine Reihe von charakteristischen Eigenschaften auf, welche sie zur Verwendung als Isolatoren zwischen einzelnen Metallagen geeignet machen. Hervorzuheben ist, daß Polyimid im Gegensatz zu Plasmanitrid die darunterliegenden Topographien planarisiert und damit eine ausgezeichnete Ausgangslage für das Aufbringen der zweiten Metallisierung schafft. Eine weitere wichtige Eigenschaft ist seine niedrige Dielektrizitätskonstante von 3.5. Besonders günstige Voraussetzungen für die Isolation zwischen der sehr dichten ersten Metallisierung und der zweiten Metallisierung werden geschaffen, wenn zuerst eine Nitridschicht und dann eine Polyimidschicht aufgetragen wird.

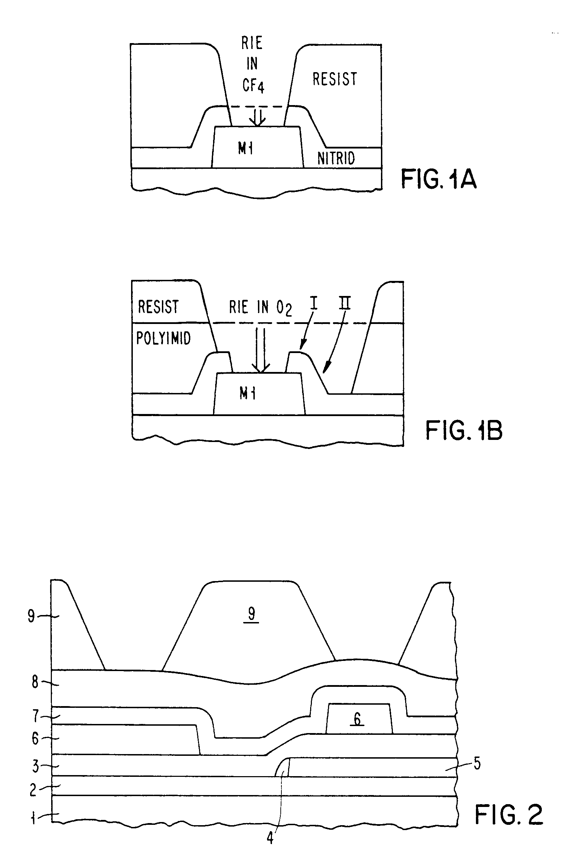

Nach dem Stand der Technik (Fign. 1A und 1B) wird auf einem Halbleitersubstrat mit einer ersten Metallisierung M 1 nach bekannten Verfahren eine konforme Siliciumnitridschicht abgeschieden, und es werden mit Hilfe der Photolithographie und eines Trockenätzverfahrens auf der Basis von $CF_4$ in derselben Kontaktöffnungen hergestellt, deren Abmessungen die Kontaktfläche von Metall 1 zu Metall 2 bestimmen. Anschließend wird eine Polyimidschicht aufgesponnen. Die Kontaktöffnungen in der Polyimidschicht werden mit einer zweiten Maske definiert und sind deshalb nicht selbstjustiert zu den Öffnungen in der Nitridschicht. Beim reaktiven Ionenätzen der Kontaktöffnungen in die Polyimidschicht mit $O_2$ entstehen auch mehrere steile Stufen (I, II Fig. 2B), welche von der zweiten Metallisierung bedeckt werden müssen.

Mit dem Verfahren gemäß der Erfindung können unter Zuhilfenahme eines Photoresistprozesses mit Doppelbelichtung und eines mehrstufigen, besonders ausgestalteten Trockenätzprozesses selbstjustierte Kontaktöffnungen in einer Doppellagenisolation aus Nitrid und Polyimid hergestellt werden, welche den gewünschten Grundregeln entsprechen und ein weiches Profil aufweisen, das eine sehr gute Bedeckung durch die zweite Metallisierung gestattet, selbst wenn diese bei Zimmertemperatur aufgedampft wird. Ein besonderer Vorteil dieses Verfahrens ist, daß die Öffnungen in der Doppelschicht mit nur einer Photoresistmaske erzeugt werden können.

Es wird zunächst die Herstellung der Photoresistmaske (9), welche in Fig. 2 abgebildet ist, beschrieben. Die Unterlage, auf welche für den Photoprozeß eine Resistschicht in einer Dicke von annäherungsweise 3 bis 5 $\mu$m aufgetragen wird, besteht aus: einem Substrat (1) aus monokristallinem Silicium mit p- und n-Diffusionen (nicht dargestellt); einem halbversenkten Oxid SROX (2), welches thermisch aufgewachsen wird; dotiertem Polysilicium (5), welches durch chemische Abscheidung aus der Dampfphase bei niedrigem Druck abgeschieden wird und welches die Kanallänge des Transistors bestimmt; Abstandshaltern (4) aus Siliciumdioxid für Diffusionen; einer Isolation (3) aus Borphosphorsilicatglas; einer ersten Metallisierung (6) aus Ti und einer Al-Cu-Si-Legierung, welche durch ein Abhebeverfahren (lift-off) mit einem Positivphotoresist definiert wird; einer ersten Isolationsschicht (7) aus Siliciumnitrid, welche typischerweise eine Dicke von anäherungsweise 0.2 bis 0.8 $\mu$m aufweist, mit allen Wafertopographien konform ist und durch Plasmaabscheidung aus einer Silan, Ammoniak und Argon haltigen Atmosphäre bei einem Druck von etwa 1 mbar, einer Leistung von 100 Watt und einer Abscheidungstemperatur von etwa 300°C hergestellt wird. Schließlich wird eine zweite, planarisierende Isolationsschicht (8) aus Polyimid, welche typischerweise eine Dicke von annäherungweise 0.8 bis 2.0 $\mu$m aufweist durch Aufspinnen hergestellt.

Auf die Polyimidschicht (8) wird eine Photoresistschicht (9) in einer Dicke von anäherungsweise 3.0 bis 5.0 $\mu$m aufgesponnen. Als Photoresistmaterialien können Positivphotoresistmaterialien, beispielsweise ein Resist der Firma Shipley, der unter der Typenbezeichnung Microposit 1450J vertrieben wird und ein Phenol-Formaldehyd-Harz und einen Diazonaphthochinon- Inhibitor enthält, verwendet werden. Der Resist wird üblicherweise vor der Belichtung etwa 20 Minuten lang bei annäherungsweise 85°C und nach der Belichtung annäherungsweise 10 Minuten lang bei annäherungsweise 105°C gehärtet. Erfindungsgemäß wird die Photoresistschicht durch eine Projektionsmaske bildmäßig und dann ganzflächig belichtet. In der Praxis werden die einzelnen Chipfelder schrittweise in einem "Direct Step on Wafer" bildmäßig belichtet, gefolgt von einer ganzflächigen Belichtung der Wafer. Die Belichtung wird mit einer Strahlung von 436 nm Wellenlänge oder bei kürzeren Wellenlängen vorgenommen. Das Verhältnis von ganzflächiger Belichtungsdauer zu bildmäßiger Belichtungsdauer liegt in einem Bereich von annäherungsweise 1 : 2.0 bis 1 : 5, wobei ein Verhältnis von annäherungsweise 1 : 2.5 bevorzugt wird. Die Gesamtbelichtungsdauer beträgt in jedem Fall annäherungsweise 3.0 Sekunden. Durch den hier aufgezeigten Belichtungsprozeß, d. h. durch die auf die bildmäßige Belichtung folgende ganzflächige Belichtung wird der Photoresist nicht nur in den durch die transparenten Bereiche in der Projektionsmaske definierten Bereichen löslich, sondern insgesamt wird seine Löslichkeit in den oberen Schichten erhöht. Als Folge davon wird sich beim Entwickeln eine Neigung der Kanten in dem Photoresistmuster einstellen, d. h. die Öffnungen sind oben weiter als unten an der Grenze zum Substrat. Einzelheiten des Doppelbelichtungsverfahrens sind in der Europäischen Patentanmeldung 85 116 430.1 beschrieben, welche in Form der EP-A-227 851 publiziert wurde. Ohne Doppelbelichtung könnte man bei der schrittweisen Belichtung der einzelnen Chipfelder zwar die gewünschten kleinen Dimensionen nach den Grundregeln erhalten, nicht aber die gewünschten Kantenwinkel im Photoresistmuster, welcher für die Bedeckung mit der zweiten Metallisierung so wichtig ist. Die Größe des Kantenwinkels ist von dem Verhältnis von ganzflächiger zu bildmäßiger Belichtung abhängig. Bei dem zuvor angegebenen Verhältnis von ganzflächiger zu bildmäßiger Belichtung von annäherungsweise 1 : 2.5 werden beim Entwickeln des Resists Kantenwinkel zwischen etwa 60 und 70°, vorzugsweise von annäherungsweise 65° erhalten. Zum Entwickeln des o. angegebenen Positivphotoresists können Entwickler auf der Basis von Natriummetasilicat und Natriumphosphat, z. B. der AZ-Entwickler der Firma Shipley verwendet werden. Durch die Doppelbelichtung wird die Photoresistschicht bei der Entwicklung um etwa 30 % der Ausgangsdicke dünner.

Zur Einstellung eines bestimmten Kantenwinkels in dem Photoresistmuster wurde auch vorgeschlagen (IBM-Technical Disclosure Bulletin Vol. 28, Nr. 7, Dez. 1985, Seiten 3136 - 3137, A. Bergendahl et al), das Photoresistmuster zu erwärmen, sodaß ein Fließen des Photoresists stattfindet und sich flachere Photoresistwinkel ausbilden. Daran anschließend ist eine Veraschung mit Sauerstoff in einem RIE-System vorgesehen, um eine vollständige Entfernung des Resists aus den Bildöffnungen zu gewährleisten. Nachteilig an diesem Verfahren ist, daß, in Abhängigkeit von der Lochgröße und Lochdichte, unterschiedliche Photoresistprofile entstehen. Bei kleineren Lochdurchmessern wird ein Überhang und eine steilere Resistkante erhalten. Ein gleiches Bild ergibt sich bei hohen Lochdichten. Deshalb kann dieses Verfahren im Rahmen der vorliegenden Erfindung nicht Anwendung finden. Auf die Offenbarung des TDB's hinsichtlich des mehrstufigen Ätzens wird weiter unten eingegangen.

Der Winkel in der Photoresistmaske von annäherungsweise $65^\circ$ (Fig. 2) wird in dem nun folgenden Ätzprozeß in die Polyimidschicht (8) übertragen. Beim Ätzprozeß ist es wichtig, gleichzeitig ein gutes Ätzprofil und eine geringe Unterätzung zu erhalten. Durch letztere wird gewährleistet, daß die fertigen Kontaktöffnungen mit einer Größe von einigen um im Quadrat eine nur geringfügige Dimensionsvergrößerung (in der Größenordnung von wenigen Zehntel um) aufweisen. Da die Dicke der Polyimidschicht mit der Topologie des Untergrundes schwankt, ist auch sicherzustellen, daß alle Kontaktöffnungen geöffnet sind.

Nach dem Stand der Technik (IBM-TDB, A. Bergendahl et al) können Schichten aus unterschiedlichen Materialien anisotrop getzt werden, indem in einem mehrstufigen RIE-Verfahren die Prozeßparameter für aufeinanderfolgende kleine Inkremente der Ätztiefe einer Änderung unterliegen. Dadurch wird ein bestimmtes Profil der geätzten Öffnung erhalten. Eine $SiO_2$-Schicht wird beispielsweise stufenweise geätzt, indem Ätzschritte in $CHF_3$ und $CO_2$ mit Veraschungen des Resists in $O_2$ abwechseln. Die unter der $SiO_2$-Schicht liegende Polysiliciumschicht wird in entsprechender Weise aber unter Verwendung eines Ätzgases auf der Basis von $NF_3$ stufenweise geätzt.

Im Gegensatz zu diesem Stand der Technik wird gemäß der Erfindung die Polyimidschicht nicht in vielen kleinen Stufen geätzt, sondern 2/3 bis 3/4 derselben werden in einem Schritt mit einem Ätzgas auf der Basis von $CF_4$ durchgeätzt. Es schließt sich, zur Entkopplung der Ätzung von Polyimid und Nitrid, ein $O_2$-Ätzschritt an. Dann wird das Nitrid stufenweise mit einem Ätzgas auf der Basis von $CF_4$ im Wechsel mit Veraschungen in $O_2$ geätzt. Auf diese Weise ist beim Ätzen des Polyimids eine kleinstmögliche Unterätzung gewährleistet, und es wird ein weiches Kantenprofil in der Doppellagenisolation erhalten.

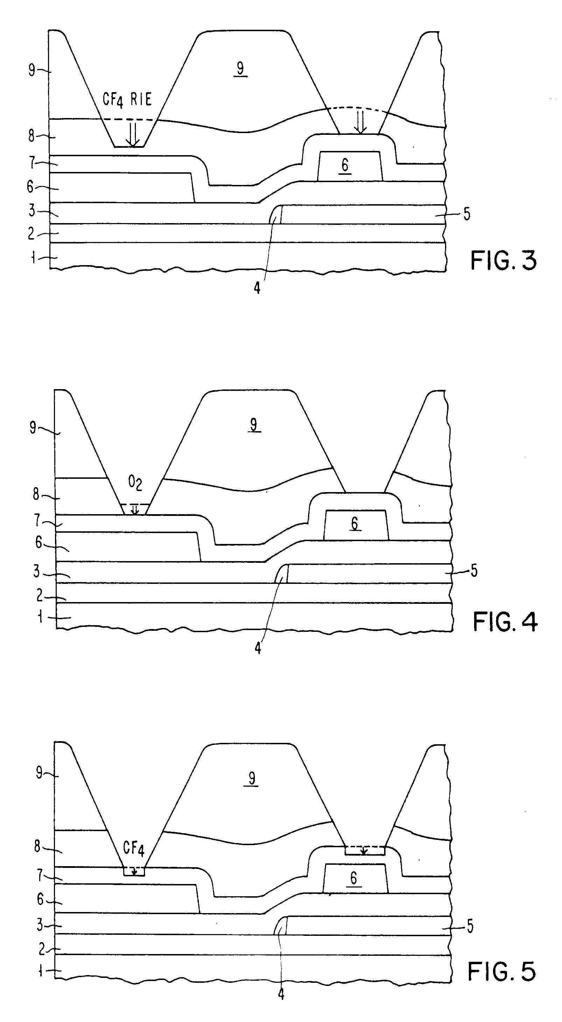

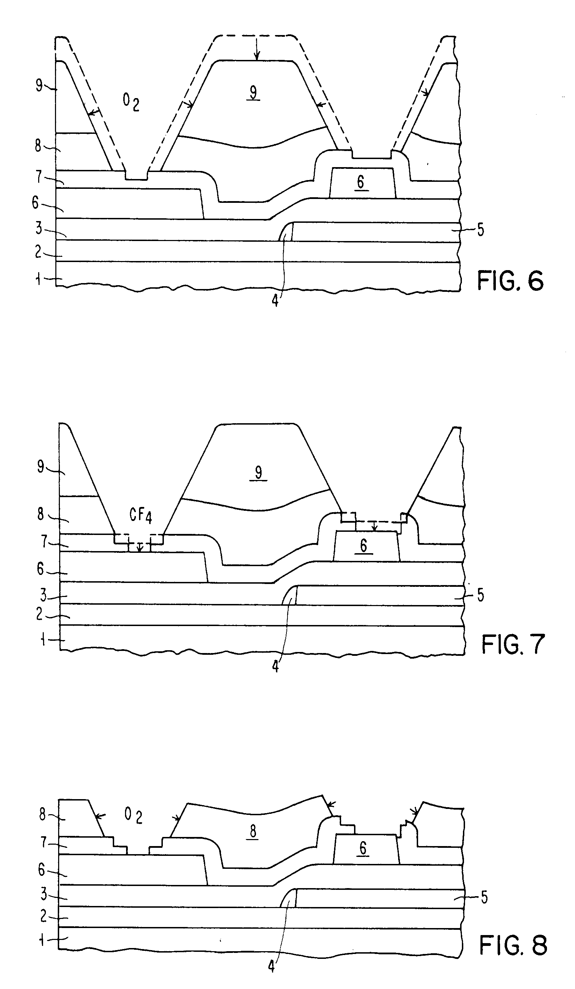

Der Ätzprozeß wird nachfolgend in zwei Abschnitten, anhand der Fign. 3 und 4 für das Polyimid und anhand der Fign. 5 bis 8 für das Nitrid, beschrieben. Da das Polyimid aufgrund seiner planarisierenden Eigenschaften an Stellen unterschiedlicher Topologie unterschiedliche Schichtdicken aufweist, werden die Kontaktöffnungen unterschiedlich lange überätzt, wobei an den Stellen, an denen das Polyimid dünner ist, wegen des Resistwinkels eine höhere Unterätzung stattfindet. Diese höhere Unterätzung würde anschließend beim Ätzen auch in die Nitridschicht übertragen werden. Um diese Dimensionsunschärfe so klein wie möglich zu halten, wird das Polyimid nicht wie bisher in Sauerstoff sondern in $CF_4$ geätzt (Fig. 3). Bei beiden Ätzgasen ist das Ätzratenverhältnis von Resist zu Polyimid annäherungsweise 1 : 1, bei $CF_4$ findet jedoch praktisch keine Unterätzung statt, während bei $O_2$ eine Unterätzung aufgrund eines lateralen Ätzens durch isotrope Ätzanteile von annäherungsweise 0.5 $\mu$m hinzukommen würde.

Der erste Ätzschritt wird in seiner Länge so bemessen, daß das Polyimid zu 2/3 bis 3/4 seiner Schichtdicke in einem Schritt geätzt wird, d. h. es wird so lange geätzt, bis es an den dünnsten Stellen gerade durchgeätzt ist (Fig. 3, rechte Kontaktöffnung). Die Endpunktsbestimmung der Ätzung erfolgt durch Laserinterferenz. Der zweite Ätzschritt wird in Sauerstoff durchgeführt. Bei diesem Ätzschritt wirkt das Nitrid als Ätzstop. Er wird in seiner Länge so bemessen, daß das Nitrid in allen Kontaktöffnungen freigelegt ist (Fig. 4). Dieser Ätzschritt mit Sauerstoff verursacht eine Unterätzung von bis zu 0.2 $\mu$m pro Kontaktöffnung. Nach diesem Ätzschritt, welcher das Ätzen von Polyimid und Nitrid entkoppelt, wird das Ätzen des Nitrids in einem mehrstufigen Verfahren durchgeführt.

Das bisherige Verfahren sah ein reaktives Ionenätzen in $CF_4$ in einem Schritt vor. Nachteilig an diesem Verfahren war, daß dabei eine relativ hohe Stufe im Nitrid gebildet wurde, was schon zu Unterbrechungen in der zweiten Metallisierung geführt hatte. Deshalb sieht das Verfahren gemäß der Erfindung eine Folge von mindestens zwei vertikalen reaktiven Ionenätzschritten vor, welche von einer lateralen Veraschung in Sauerstoff unterbrochen wird (Fign. 5, 6 und 7). In einem letzten Schritt wird noch einmal eine Veraschung in Sauerstoff durchgeführt (Fig. 8). Diese bewirkt, daß das Polyimid gegenüber der Nitridstufe noch einmal zurückgesetzt wird. Dadurch wird die Steilheit des Profils der Kontaktöffnungen noch weiter entschärft. Die Unterätzung bei dieser Folge von Ätzschritten ist äußerst gering und liegt in der Größenordnung von < 0.1 $\mu$m. Durch das reaktive Ionenätzen von Polyimid und Nitrid wurde etwa die Hälfte der Resistdicke verbraucht, wobei der größte Anteil während des Polyimidätzens und der kleinste Anteil während der Veraschung mit Sauerstoff verbraucht wurde. Dadurch war gewährleistet, daß während des ganzen Verfahrens immer genügend restlicher Photoresist vorhanden war, um einen nicht erwünschten Angriff auf das Polyimid an erhöhten Stellen zu vermeiden. Der restliche Photoresist wird mit N-Methylpyrrolidon gestrippt.

Übersicht der Verfahren:

|  | Stand der Technik | Erfindung |
|---|---|---|
| Nitridabscheidung | ja | ja |
| Resistvorbehandlung | ja | nein |
| Resistauftrag | ja | nein |
| Belichtung, Entwicklung | ja | nein |
| Ätzen | ja | nein |
| Reststrip | ja | nein |
| Polyimidvorbehandlung | ja | ja |
| Polyimidauftrag | ja | ja |
| Resistauftrag | ja | ja |
| bildmäßige Belichtung | ja | ja |
| ganzflächige Belichtung | ja | ja |
| Entwicklung | ja | ja |
| Ätzen | ja | ja |
| Reststrip | ja | ja |

Spezielles Ausführungsbeispiel:

A) Photoprozeß:

Es wird ein Positivphotoresist TF 20 der Fa. Shipley auf Novolakbasis mit einem Diazonaphthochinon-Inhibitor und 0.35 % Oracetfarbstoff (Warenzeichen der Fa. Ciba-Geigy) in einer Schichtdicke von 4.8 $\mu$m verwendet. Das Verhältnis von ganzflächiger zu bildmäßiger Belichtung lag bei 1 : 2.5, wobei die ganzflächige Belichtung 0.8 Sek. und die bildmäßige 2.2 Sek. betrug. Die belichteten Wafer wurden etwa 10 Min. lang bei 105° C nachgehärtet und anschließend mit AZ-Entwickler, Verh. 1 : 1 bis zum Endpunkt zuzüglich 50 % entwickelt. Die Resistschichtdicke lag nach der Entwicklung bei etwa 3 $\mu$m und der Kantenwinkel des Photoresists bei etwa 65° (Fig. 2). Die Schichtdicken von Polyimid und Nitrid waren 0.85 bzw. 0.4 $\mu$m.

B) Ätzprozeß:

Alle Ätzschritte werden nacheinander in einem HIPRO-Parallelplatten- RIE-System durchgeführt. Hierzu ebenso geeignet sind beispielsweise Hexoden-RIE-Systeme wie AME 8100, oder manche Einscheibenätzgeräte. Die nachfolgend angegebenen RIE-Parameter sind Erfahrungswerte, welche sehr gute Ergebnisse ergaben. Für die Anwendung in anderen RIE-Systemen könnte eine Modifikation dieser Parameter notwendig sein.

Polyimid (0.85 μm)   1. Schritt :

                  Fig. 3

| | |
|---|---|
| Ätzmedium | $CF_4$ |
| Fluß | 30 sccm |
| Druck | 65 μbar |
| Leistung | 300 Watt |

Es werden etwa 0.7 μm Polyimid durchgeätzt, was etwa 75 % entspricht. Das Ätzratenverhältnis von Resist zu Polyimid ist 1 : 1.

           2. Schritt :

              Fig. 4

| | |
|---|---|
| Ätzmedium | $O_2$ |
| Fluß | 40 sccm |
| Druck | 100 μbar |
| Leistung | 300 Watt |

Es werden etwa 0.3 μm geätzt, wobei 0.15 μm auf die Ätzung bis zum Endpunkt und 0.15 μm auf eine Überätzung entfallen.

Nitrid (0.4 μm)     1 Schritt :

              Fig. 5

| | |
|---|---|
| Ätzmedium | $CF_4$ |
| Fluß | 30 sccm |
| Druck | 65 μbar |
| Leistung | 300 Watt |

Es werden etwa 0.25 μm Nitrid durchgeätzt, was etwa 60 % entspricht.

## 2. Schritt :
### Fig. 6

| | |
|---|---|
| Ätzmedium | $O_2$ |
| Fluß | 40 sccm |
| Druck | 100 μbar |
| Leistung | 200 Watt |

Es wird vertikal geätzt, um über den Winkel des Resists eine laterale Verschiebung des Resists und des Polyimids von 0.15 μm zu erreichen.

## 3. Schritt :
### Fig. 7

| | |
|---|---|
| Ätzmedium | $CF_4$ |
| Fluß | 30 sccm |
| Druck | 65 μbar |
| Leistung | 300 Watt |

Es werden etwa 0.25 μm geätzt, wobei 0.15 μm auf die Ätzung bis zum Endpunkt und 0.1 μm auf eine Überätzung entfallen.

4. Schritt :

Fig. 8

| | |
|---|---|
| Ätzmedium | $O_2$ |
| Fluß | 40 sccm |
| Druck | 100 µbar |
| Leistung | 200 Watt |

Es wird vertikal geätzt, um über den Winkel des Resists eine laterale Verschiebung des Resists und des Polyimids von 0.15 µm zu erreichen. Der lateralen Ätzung des Polyimids von je 0.15 µm in den Schritten 2 und 4 entspricht ein Vertikalabtrag des Resists von je 0.3 µm.

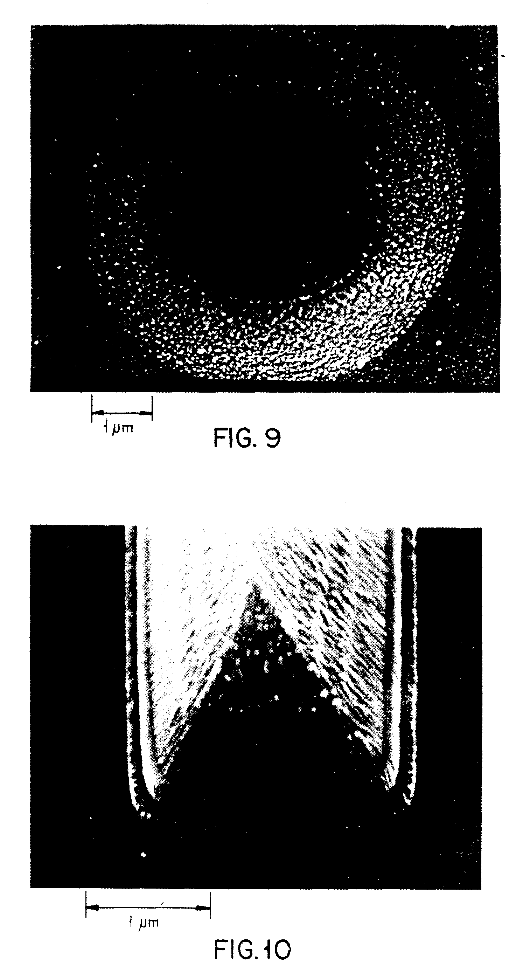

In Fig. 9 ist eine SEM-Aufnahme einer nach dem Verfahren gemäß der Erfindung hergestellten Kontaktöffnung dargestellt. Die beiden Ringe im Innern der Öffnung sind die Stufen im Nitrid, an die sich das Polyimid nach außen mit einem weichen Profil anschließt.

In Fig. 10 ist eine SEM-Aufnahme gezeigt, in der die dunklen Bereiche die erste Metallisierung darstellen. Deutlich erkennbar sind in der Wandung der Isolation die beiden ersten Stufen aus Nitrid und darüber das Polyimid mit dem gewünschten Kantenwinkel.

Die SEM's zeigen die Ergebnisse eines genau kontrollierten Ätzprozesses. Die Winkel in der Photoresistschicht von etwa 60 bis 70° werden in die Polyimidschicht mit Winkeln ≦ 60° übertragen, d. h. die Profile werden während des Ätzens etwas flacher. Die Kontaktöffnungen weisen weiche Konturen bzw. niedrige Stufen auf. Aufgrund der Selbstjustierung von Nitrid- und Polyimidöffnung entsteht insgesamt weniger Topologie als bei dem bisher bekannten Verfahren (Fign. 1A und 1B). Die äußere Stufe im Nitrid, welche durch die konforme Bedeckung des ersten Metalls zustandekommt, fehlt. Die Stufenhöhe der inneren Stufe ist durch die Aufteilung in eine Doppelstufe entschärft. Der Ätzprozeß gemäß der Erfindung ist besonders vorteilhaft hinsichtlich einer guten Metallabdeckung, insbesondere bei Anwendung des Metallabhebeverfahrens (lift-off) oder bei Metallbedampfung, beispielsweise von Ti-Al-Cu bei Raumtemperatur. Die Kontaktöffnungen, welche nach dem Verfahren gemäß hergestellt wurden, weisen ausgezeichnete Widerstandswerte auf, die in der Größenordnung von 0.3 Ω pro Öffnung liegen.

**Patentansprüche**

**1.** Verfahren zum Herstellen von Kontaktöffnungen in einer Doppellagenisolation, welches folgende Verfahrensschritte umfaßt:

(1) Aufbringen einer ersten Isolationsschicht (7) aus anorganischem Material auf ein Substrat mit einer ersten Metallisierung (6);

(2) Aufbringen einer zweiten Isolationsschicht (8) aus Polymermaterial auf die erste Isolationsschicht (7);

(3) Aufbringen einer Schicht (9) aus einem Positivphotoresist auf die Doppelschicht (7, 8) und Vorhärten;

(4) bildmäßiges Belichten der Photoresistschicht (9) und anschließend ganzflächiges Belichten derselben und Nachhärten;

(5) Entwickeln der Photoresistschicht (9) mit einem basischen Entwickler;

(6) Reaktives Ionenätzen (RIE) mit einem ersten Ätzgas von etwa 2/3 bis 3/4 der zweiten Isolationsschicht (8) in den durch die Photoresistmaske freigelegten Bereichen der gewünschten Kontaktöffnungen;

(7) RIE mit einem zweiten Ätzgas zur vollständigen Entfernung der zweiten Isolationsschicht (8) in den durch die Maske freigelegten Bereichen, wobei die erste Isolationsschicht (7) als Ätzstop dient;

(8) RIE mit dem ersten Ätzgas von etwa der Hälfte der ersten Isolationsschicht (7);

(9) RIE mit dem zweiten Ätzgas, um über den Winkel des Resists eine laterale Verschiebung des Photoresists (9) und der zweiten Isolationsschicht (8) zu erreichen;

(10) RIE mit dem ersten Ätzgas von der zweiten Hälfte der ersten Isolationsschicht (7);

(11) RIE mit dem zweiten Ätzgas, um über den Winkel des Resists eine laterale Verschiebung des Photoresists (9) und der zweiten Isolationsschicht (8) zu erreichen und

(12) Strippen des restlichen Photoresists (9).

2. Verfahren nach Anspruch 1, dadurch gekennzeichnet, daß als erste Isolationsschicht eine mit allen Wafertopographien konforme Siliciumnitridschicht (7) durch Plasmaabscheidung aufgebracht wird.

3. Verfahren nach Anspruch 2, dadurch gekennzeichnet, daß die Siliciumnitridschicht eine Dicke zwischen annäherungsweise 0.2 und 0.8 $\mu$m aufweist.

4. Verfahren nach Anspruch 1, dadurch gekennzeichnet, daß als zweite Isolationsschicht eine planarisierende Polyimidschicht (8) durch Aufspinnen aufgebracht wird.

5. Verfahren nach Anspruch 4, dadurch gekennzeichnet, daß die Polyimidschicht eine Dicke von annäherungsweise 0.8 bis 2 $\mu$m aufweist.

6. Verfahren nach Anspruch 1, dadurch gekennzeichnet, daß auf die Doppelschicht (7, 8) ein Positivphotoresist (9) auf Novolakbasis mit einem Diazonaphthochinon-Inhibitor in einer Dicke von annäherungsweise 3 bis 5 $\mu$m aufgebracht wird.

7. Verfahren nach den Ansprüchen 1 und 6, dadurch gekennzeichnet, daß bildmäßige Belichtung und ganzflächige Bestrahlung der Photoresistschicht mit einer Strahlung von 436 nm Wellenlänge oder bei kürzeren Wellenlängen vorgenommen wird.

8. Verfahren nach den Ansprüchen 1, 6 und 7, dadurch gekennzeichnet, daß der Neigungswinkel der Photoresistkanten über das Verhältnis von ganzflächiger zu bildmäßiger Belichtungsdauer gesteuert wird.

9. Verfahren nach Anspruch 8, dadurch gekennzeichnet, daß das Verhältnis von ganzflächiger zu bildmäßiger Belichtungsdauer zwischen annäherungsweise 1 : 2.0 und 1 : 5 liegt.

10. Verfahren nach Anspruch 9, dadurch gekennzeichnet, daß das Verhältnis von ganzflächiger zu bildmäßiger Belichtungsdauer 1 : 2.5 ist.

11. Verfahren nach Anspruch 1, dadurch gekennzeichnet, daß die Photoresistschicht vor dem Belichten annäherungsweise 20 Minuten lang bei annäherungsweise 85 $^\circ$C vorgehärtet und nach der ganzflächigen Bestrahlung annäherungsweise 10 Minuten lang bei annäherungsweise 105 $^\circ$C nachgehärtet wird.

12. Verfahren nach Anspruch 1, dadurch gekennzeichnet, daß als erstes Ätzgas $CF_4$ und als zweites Ätzgas Sauerstoff verwendet wird.

13. Verfahren nach den Ansprüchen 1 und 11, dadurch gekennzeichnet, daß RIE von Polyimid und von Nitrid in $CF_4$ durch einen RIE-Ätzschritt in Sauerstoff entkoppelt wird.

14. Verfahren nach Anspruch 1, dadurch gekennzeichnet, daß das Ätzratenverhältnis von Photoresist zu Polyimid annäherungsweise 1 : 1 ist.

15. Verfahren nach Anspruch 13, dadurch gekennzeichnet, daß der RIE-Ätzschritt von Polyimid in Sauerstoff bei einem Druck $\leqq$ 100 $\mu$bar vorgenommen wird.

16. Verfahren nach Anspruch 1, dadurch gekennzeichnet, daß nach der Herstellung der Kontaktöffnungen in der Doppelschicht (7, 8) die zweite Metallisierung aufgebracht wird.

17. Verfahren nach Anspruch 16, dadurch gekennzeichnet, daß als zweite Metallisierung Ti-Al-Cu bei Raumtemperatur aufgedampft wird.

**Claims**

1. Method of making via holes in a double-layer insulation, comprising the following steps:

(1) applying a first insulation layer (7) of inorganic material onto a substrate with a first metallurgy (6);
(2) applying a second insulation layer (8) of polymeric material onto the first insulation layer (7);
(3) applying a layer (3) of positive photoresist on the double layer (7,8) and pre-baking;
(4) image-wise exposure of the photoresist layer (9) and subsequent blanket exposure thereof, and post-baking;
(5) developing the photoresist layer (9) with a basic developer;
(6) reactive ion etching (RIE) with a first etching gas of approx. 2/3 to 3/4 of the second insulation layer (8) in the areas of the respective via holes exposed by the photoresist mask;
(7) RIE with a second etching gas for completely removing the second insulation layer (8) in the areas exposed by the mask, with the first insulation layer (7) serving as an etch stop;
(8) RIE with the first etching gas of approx. half of the first insulation layer (7);
(9) RIE with the second etching gas to effect via the angle of the resist a lateral shifting of the photoresist (9) and of the second insulation layer (8);
(10) RIE with the first etching gas of the second half of the first insulation layer (7);
(11) RIE with the second etching gas to effect via the angle of the resist a lateral shifting of the photoresist (9) and of the second insulation layer (8), and
(12) stripping the residual photoresist (9).

2. Method as claimed in Claim 1, characterized in that as first insulation layer a silicon nitride layer (7) conformal with all wafer topographies is applied by plasma deposition.

3. Method as claimed in Claim 2, characterized in that the silicon nitride layer has a thickness between approximately 0.2 and 0.8 $\mu$m.

4. Method as claimed in Claim 1, characterized in that as second insulation layer a planarizing polyimide layer (8) is applied by spinning-on.

5. Method as claimed in Claim 4, characterized in that the polyimide layer has a thickness of approximately 0.8 to 2 $\mu$m.

6. Method as claimed in Claim 1, characterized in that onto the double layer (7, 8) a positive photoresist (9) on Novolak basis with a diazonaphthoquinone inhibitor is applied with a thickness of approximately 3 to 5 $\mu$m.

7. Method as claimed in any one of Claims 1 and 6, characterized in that an image-wise exposure and blanket exposure of the photoresist layer is performed with a radiation of 436 nm wave length, or with shorter wave lengths.

8. Method as claimed in any one of Claims 1, 6 and 7, characterized in that the slope angle of the photoresist edges is controlled via the ratio of blanket to image-wise exposure duration.

9. Method as claimed in Claim 8, characterized in that the ratio of blanket to image-wise exposure duration is between approximately 1 : 2.0 and 1 : 5.

10. Method as claimed in Claim 9, characterized in that the ratio of blanket to image-wise exposure is 1 : 2.5.

11. Method as claimed in Claim 1, characterized in that the photoresist layer is pre-baked prior to exposure for approximately 20 minutes at approximately 85 $^\circ$C, and post-baked after blanket irradiation for approximately 10 minutes at approximately 105 $^\circ$C.

**12.** Method as claimed in Claim 1, characterized in that as a first etching gas $CF_4$, and as a second etching gas oxygen is used.

**13.** Method as claimed in Claims 1 and 11, characterized in that RIE of polyimide and of nitride in $CF_4$ is decoupled by an RIE etching step in oxygen.

**14.** Method as claimed in Claim 1, characterized in that the etching rate ratio of photoresist to polyimide is approximately 1 : 1.

**15.** Method as claimed in Claim 13, characterized in that the RIE etching step of polyimide in oxygen is performed at a pressure $\leq 100$ $\mu$bar.

**16.** Method as claimed in Claim 1, characterized in that after the making of the via holes in the double-layer (7, 8) the second metallurgy is deposited.

**17.** Method as claimed in Claim 16, characterized in that as second metallurgy Ti-Al-Cu is vapor deposited at room temperature.

**Revendications**

**1.** Procédé pour fabriquer des trous de contact dans une double couche d'isolation, caractérisé en ce qu'il comprend les opérations suivantes :

(1) application d'une première couche isolante (7) en matériau inorganique sur un substrat avec une première métallisation (6) ;

(2) application d'une deuxième couche isolante (8) en matériau polymère sur la première couche isolante (7) ;

(3) application d'une couche (9) photosensible positive sur la double couche (7, 8) et prédurcissement ;

(4) exposition lumineuse de l'image de la couche photosensible (9), et finalement exposition de toute la surface de ladite couche photosensible, et postdurcissement ;

(5) Développement de la couche photosensible (9) avec un révélateur basique ;

(6) attaque ionique réactive (RIE), avec un premier gaz d'attaque, d'environ 2/3 à 3/4 de la deuxième couche isolante (8) dans les zones des trous de contact souhaités, découvertes par le masque photosensible ;

(7) RIE avec un deuxième gaz d'attaque pour éliminer complètement la deuxième couche isolante (8) dans les zones dégagées du masque, la première couche isolante servant d'arrêt d'attaque ;

(8) RIE, avec le premier gaz d'attaque, d'environ la moitié de la première couche isolante (7) ;

(9) RIE, avec le deuxième gaz d'attaque, pour obtenir un déplacement latéral de la couche photosensible (9) et de la deuxième couche isolante (8) sur l'angle de la couche photosensible ;

(10)RIE, avec le premier gaz d'attaque, de la deuxième moitié de la première couche isolante (7) ;

(11)RIE, avec le deuxième gaz d'attaque, pour obtenir un déplacement latéral de la couche photosensible (9) et de la deuxième couche isolante (8) sur l'angle de la couche photosensible ; et

(12) élimination de la couche photosensible restante (9).

**2.** Procédé selon la revendication 1, caractérisé en ce que la première couche isolante est une couche de nitrure de silicium (7) conforme à la topographie de toutes les tranches de silicium, qu'on applique par dépôt au plasma.

**3.** Procédé selon la revendication 2, caractérisé en ce que la couche de nitrure de silicium a une épaisseur comprise entre environ 0,2 et 0,8 $\mu$m.

**4.** Procédé selon la revendication 1, caractérisé en ce que la deuxième couche isolante est une couche de polyimide planarisante (8) qu'on applique par filage.

**5.** Procédé selon la revendication 4, caractérisé en ce que la couche de polyimide a une épaisseur d'environ 0,8 à 2 $\mu$m.

**6.** Procédé selon la revendication 1, caractérisé en ce qu on applique, sur la double couche (7, 8), une couche photosensible positive (9) à base de novolaque avec un inhibiteur de diazonaphtoquinone, sur une épaisseur d'environ 3 à 5 $\mu$m.

7. Procédé selon les revendications 1 à 6, caractérisé en ce que l'exposition lumineuse de l'image et l'irradiation de toute la surface de la couche photosensible sont réalisées avec un rayonnement à une longueur d'onde de 436 nm ou des longueurs d'onde plus courtes.

8. Procédé selon les revendications 1, 6 et 7, caractérisé en ce que l'angle d'inclinaison des bords de la couche photosensible est commandé par le rapport du temps d'exposition de toute la surface sur le temps d'exposition de l'image.

9. Procédé selon la revendication 8, caractérisé en ce que le rapport du temps d'exposition de toute la surface sur le temps d'exposition de l'image est compris entre environ 1 : 2 et 1 : 5.

10. Procédé selon la revendication 9, caractérisé en ce que le rapport du temps d'exposition de toute la surface sur le temps d'exposition de l'image est de 1 : 2,5.

11. Procédé selon la revendication 1, caractérisé en ce que la couche photosensible est prédurcie pendant environ 20 minutes à environ 85˚C avant l'exposition, et post-durcie pendant environ 10 minutes à environ 105˚C après l'exposition de toute la surface.

12. Procédé selon la revendication 1, caractérisé en ce qu'on utilise du $CF_4$ comme premier gaz d'attaque et de l'oxygène comme deuxième gaz d'attaque.

13. Procédé selon les revendications 1 et 11, caractérisé en ce que la RIE du polyimide et la RIE du nitrure au $CF_4$ sont découplées par une opération d'attaque RIE à l'oxygène.

14. Procédé selon la revendication 1, caractérisé en ce que le rapport de la vitesse d'attaque de la couche photosensible sur la vitesse d'attaque du polyimide est d'environ 1:1.

15. Procédé selon la revendication 13, caractérisé en ce que l'opération d'attaque RIE du polyimide dans l'oxygène est réalisée à une pression ≦ 100 $\mu$bar.

16. Procédé selon la revendication 1, caractérisé en ce qu'on applique la deuxième métallisation après la fabrication des trous de contact dans la double couche (7, 8).

17. Procédé selon la revendication 16, caractérisé en ce qu'on réalise la deuxième métallisation en métallisant sous vide du Ti-Al-Cu à la température ambiante.

FIG. 1A

FIG. 1B

FIG. 2

FIG. 3

FIG. 4

FIG. 5

FIG. 6

FIG. 7

FIG. 8

FIG. 9

FIG. 10